# EUROPEAN PATENT APPLICATION

(11) **EP 1 816 675 A1**
(43) Date of publication of application: **08.08.2007**
(21) Application number: 06425059.0
(22) Date of filing: 03.02.2006
(51) Int. Cl.: H01L 21/8247, H01L 27/105

(54) **Manufacturing process of spacers for high-voltage transistors in an EEPROM device**

(71) Applicant: STMicroelectronics S.r.l., 20041 Agrate Brianza (Milano) (IT)
(72) Inventor: Costantini, Sonia, 23876 Monticello (LC) (IT); Pavan, Alessia, 23807 Merate (LC) (IT); Servalli, Giorgio, 24040 Ciserano (BG) (IT)
(74) Representative: Ferrari, Barbara

(57) **Abstract**

Process for manufacturing a non volatile memory electronic device (2) integrated on a semiconductor substrate (1) which comprises a matrix of non volatile memory cells (4), said memory cells (4) organised in rows, called word lines, and columns, called bit lines and an associated circuitry comprising high voltage transistors (3), comprising the steps of:
- forming, by means of a photo-lithographic process which provides the use of a first photo-lithographic mask, gate electrodes (12) of the high voltage transistors (3) projecting from a first portion (A) of the semiconductor substrate (1).
- forming first spacers (15) on the side walls of the gate electrodes (12) of said high voltage transistors (3) of a first length (L1),
- forming, by means of a photo-lithographic process which provides the use of a second photo lithographic mask which covers said high voltage transistors (3), gate electrodes (16) of said memory cells (4) projecting from a second portion (B) of said semiconductor substrate (1), each of said gate electrodes (16) of memory cells (4) comprising a floating gate electrode (FG) and a control gate electrode (CG)

## Description

### Field of application

The present invention relates to a process for manufacturing, on a semiconductor substrate, a memory electronic device comprising a matrix of non volatile memory cells and an associated circuitry.

The invention particularly, but not exclusively, relates to a process for manufacturing, on a semiconductor substrate, a memory electronic device comprising a matrix of non volatile memory cells of the Flash type with NOR or NAND architecture, and a circuitry comprising transistors handling high voltages and, advantageously, also transistors handling low voltages and the following description is made with reference to this field of application by way of illustration only.

### Prior art

As it is well known, non volatile memory electronic devices, for example of the Flash type, integrated on semiconductor substrate comprise a plurality of non volatile memory cells organised in matrix, i.e. the cells are organised in rows, called word lines, and columns, called bit lines.

Each single non volatile memory cell comprises a MOS transistor wherein the gate electrode, arranged above the channel region, is floating, i.e. it shows a DC high impedance towards all the other terminals of the same cell and of the circuit wherein the cell is inserted.

The cell also comprises a second electrode, called control gate, which is capacitively coupled to the floating gate electrode through an intermediate dielectric layer, so called interpoly. This second electrode is driven through suitable control voltages. The other electrodes of the transistor are the usual drain, source terminals.

The cells belonging to a same word line share the electric line which drives the respective control gate electrodes, while the cells belonging to a same bit line share the drain terminals.

Conventionally, memory electronic devices also comprise a control circuitry associated with the matrix of memory cells. The control circuitry comprises conventional MOS transistors, each of them having a source region and a drain region separated by a channel region. A gate electrode is then formed on the channel region and insulated therefrom by means of a gate oxide layer. The gate electrode can be provided, on its side walls, with spacing elements called spacers.

In particular, in the circuitry of Flash non volatile memory devices organised with NOR or NAND architectures transistors dedicated to handle high voltages (High Voltage circuitry) are integrated.

In memory electronic devices with NOR architecture of advanced technology, the formation of the spacers of the transistors dedicated to handle high voltages is complicated by the fact that the space between the gate electrodes of the memory cells can be completely filled in with the materials the spacers themselves are realised with, therefore, the definition of spacers and contacts between the memory cells is complicated. This technological difficulty thus requires the definition of differential spacers between matrix and High Voltage circuitry.

Moreover, memory electronic devices with NOR architecture of advanced technology often need to integrate, in the circuitry, also transistors showing high performances for embedded applications and to carry out, at high speed, complex management algorithms of the memory devices themselves (Low Voltage circuitry).

For the transistors of the LV circuitry the process steps relative to the realisation of the junction implants and of the spacers are particularly complex. Also in this case the integration of the HV circuitry transistors makes it often necessary the introduction of spacers and junction implants for forming the differential source and drain regions.

A prior art solution for the definition of the differential spacers provides the addition, to the conventional process flow, of a mask specific for the separation of the HV circuitry and of the memory matrix.

Although advantageous under several aspects, this solution shows the drawback of being expensive and of requiring a complex sequence of selective etchings on the diclcctrics.

The technical problem underlying the present invention is that of devising a process for manufacturing a memory device comprising a matrix of non volatile memory cells of the Floating Gate type and transistors able to handle the high writing voltages of the memory cell, having such characteristics as to overcome the limits still affecting the devices realised according to the prior art.

### Summary of the invention

The solution idea underlying the present invention is that of forming a memory electronic device wherein gate electrodes and spacers of high voltage transistors arc formed before realising the memory cells.

Advantageously, the memory electronic device also comprises low voltage transistors whose gate electrodes are realised after having formed gate electrodes of the memory cells.

On the basis of this solution idea the technical problem is solved with a process of the type as previously indicated and defined by the characterising part of claim 1.

The characteristics and the advantages of the device according to the invention will be apparent from the following description of an embodiment thereof given by way of indicative and non, limiting example with reference to the annexed drawings.

### Brief description of the drawings

In these drawings:
- figures 1A to 9A, respectively show vertical section schematic views of a first portion of a memory electronic device 2 during some manufacturing steps of the process according to the invention,
- figures 1B to 9B show vertical section schematic views of a second portion of a memory electronic device 2 during some manufacturing steps of the process according to the invention,
- figures 4D to 4E show vertical section schematic views of some manufacturing steps only the second portion is subjected to,

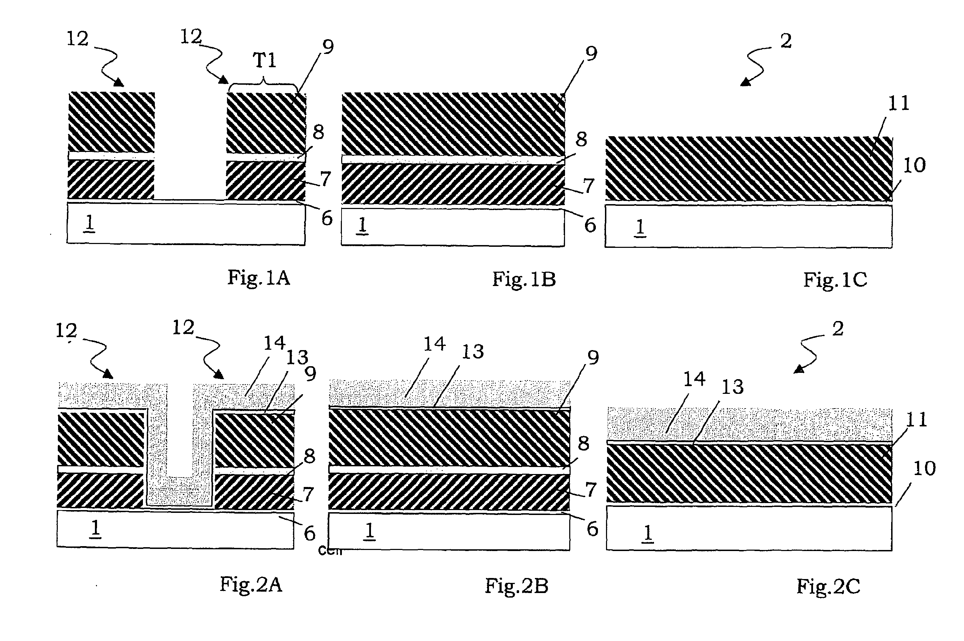

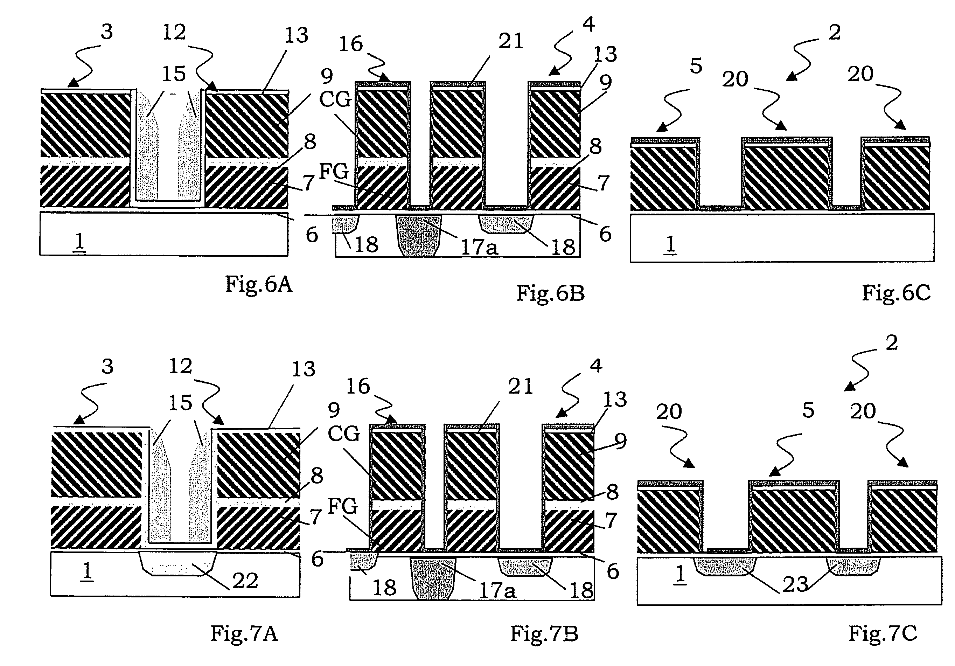

- figures 1C to 9C show vertical section schematic views of a third portion of a memory electronic device 2 during some manufacturing steps of the process according to the invention.

### Detailed description

With reference to these figures, a, process is described for manufacturing, on a semiconductor substrate, a memory electronic device comprising a matrix of non volatile memory cells, and a circuitry comprising transistors handling high voltages.

Advantageously, the matrix comprises Flash non volatile memory cells organised with architectures of the NOR type.

Advantageously the circuitry also comprises transistors handling low voltages.

The process steps described hereafter do not form a complete process flow for the manufacturing of integrated circuits. The present invention can be put into practice together with the manufacturing techniques of the integrated circuits currently used in the field, and only those process steps being commonly used and necessary for the comprehension of the present invention are included.

The figures showing perspective views of portions of an integrated circuit during the manufacturing are not drawn to scale but they are instead drawn so as to show the important characteristics of the invention.

In particular, on a semiconductor substrate 1 a memory electronic device 2 is formed comprising high voltage transistors 3 formed in a first portion A of the semiconductor substrate 1, a matrix of memory cells 4 formed in a second portion B of the semiconductor substrate 1 and, advantageously, low voltage transistors 5 formed in a third portion C of the semiconductor substrate 1.

In a known way, on the semiconductor substrate 1, active areas are formed delimited by an insulation layer, for example a field oxide layer, for the memory cells 4 and the transistors 3, 5 of the circuitry.

On the semiconductor substrate 1 a first insulating layer 6, for example formed by a silicon oxide layer called gate, a first conductive layer 7, for example of polysilicon, are then formed in cascade.

Floating gate FG electrodes of the memory cells 1 with width W are defined along a direction perpendicular to the plane of the drawings, for example by means of etching of the first conductor layer 7 through a first mask provided, with openings in correspondence with the second portion B of the semiconductor substrate 1.

In this step the first conductor layer 7 is completely removed from the third portion C of the semiconductor substrate 1.

Nothing forbids that the formation of the active areas for the memory cells 4 and the transistors 3, 5 of the circuitry and the definition of the width of the floating gate FG electrodes of the cells occurs with other known process steps.

As shown in figures 1A to 1B, in the portion A and in the portion B of the semiconductor substrate 1, a second insulating layer 8 and a second conductive layer 9, for example of polysilicon, are then formed in cascade.

Advantageously, the second insulating layer 8, called interpoly dielectric, is formed by a triple layer comprising a first silicon oxide layer, a silicon nitride layer and a second silicon oxide layer.

Advantageously, as shown in figure 1C, in the portion C of the semiconductor substrate 1, a third insulating layer 10, for example gate oxide, a third conductive layer 11, for example of polysilicon, are formed in cascade.

Still advantageously, the third insulating layer 10 and the third conductive layer 11 coincide with the second insulating layer 8 and the second conductive layer 9 respectively.

According to the invention, gate electrodes 12 of the high voltage transistors 3 are formed, by using a photo-lithographic process providing the use of a first mask provided with openings in correspondence with the portion A of the semiconductor substrate 1.

This first mask completely covers the second and the third portion B and C of the semiconductor substrate 1.

Through the openings of the first mask the second conductive layer 9, the second insulating layer 8 and the first conductive layer 7 are etched in sequence so as to form gate electrodes 12 of the high voltage transistors 3 of a first length T1. Advantageously, also the first insulating layer 6 is removed.

Nothing forbids that in this step also a width of the first and of the second conductive layer is defined in the direction perpendicular to the plane of the drawings, in this first portion of the semiconductor substrate 1.

On the semiconductor substrate 1, the gate electrodes 12 of the high voltage transistors 3 are defined, as shown in figure 1A. The first and the second conductive layer 7, 9 are short-circuited with each other, for example outside the circuitry. This short-circuiting step between the first and the second conductive layer can be made at the beginning or at the end of the process according to the invention.

Once the first mask is removed, advantageously, a re-oxidation thermal treatment of the whole memory device is carried out, forming an oxide layer 13 on all the exposed conductive layers.

A first protective layer 14 is then formed on the whole memory electronic device 2 which completely coats the gate electrodes 12 of the high voltage transistors 3 as shown in figure 2A.

This first protective layer 14 can be formed also by a plurality of overlapped layers. This first protective layer 14 comprises a dielectric layer, which can be removed in a highly selective way with respect to the second conductive layer 9, and it is formed, for example, by one or more silicon oxide or silicon nitride layers.

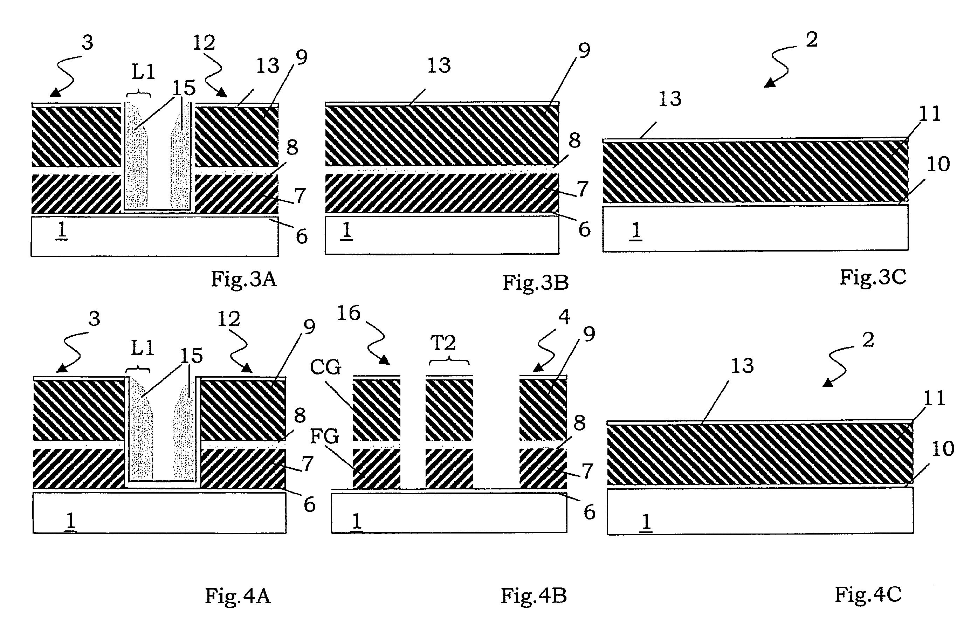

An etching step is then carried out, for example of the anisotropic type without the help of masks (etchback), of the first protective layer 14 to form first spacers 15 on the side walls of the gate electrodes 12 of the high voltage transistors 3. These first spacers 15 have a first length equal to L1, as shown in figure 3A.

During this latter etching step this first protective layer 14 is completely removed from the second and from the third portion B, C of the semiconductor substrate 1 as shown in figures 3B, 3C, thus ensuring the cleanness of the matrix areas being not yet defined.

As shown in figure 4B, gate electrodes 16 of the memory cells 4 of a second length T2 are then formed, by using a photo-lithographic process which provides the use of a second mask provided with openings in correspondence with the portion B of the semiconductor substrate 1. This second mask completely covers the first and the third portion A, C of the semiconductor substrate 1. Through the openings of the second mask the second conductive layer 9, the second insulating layer 8 and the first conductive layer 7 are etched in sequence, so as to complete the floating gate FG electrodes of the memory cells. Advantageously, also the first insulating layer 6 is removed.

In particular, with this latter etching step, the word lines of the matrix of memory cells 4 are defined in the second conductive layer 9. The portions of word lines aligned with the active area of the cells form control gate CG electrodes of the memory cells.

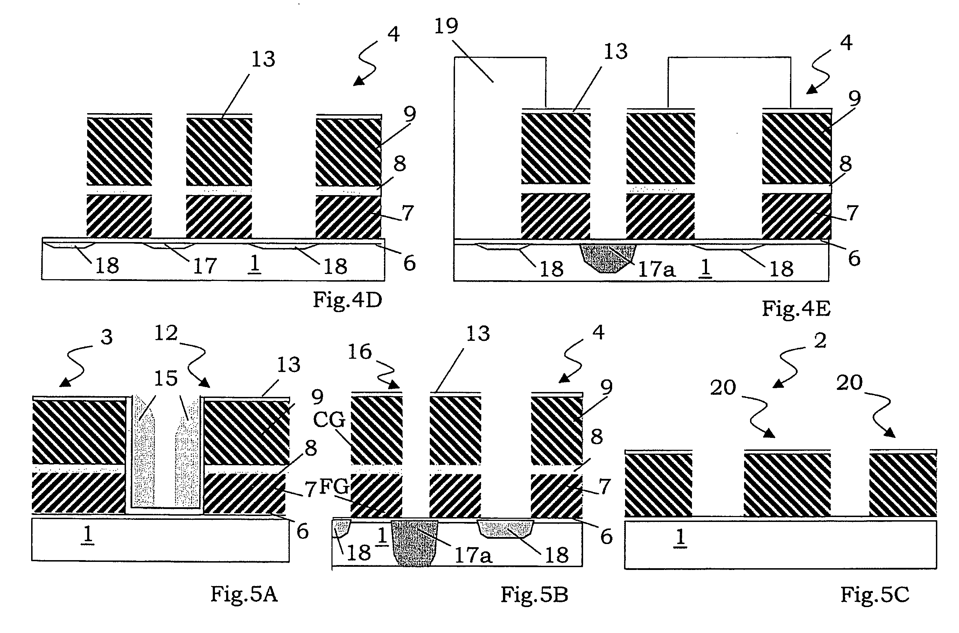

Source and drain regions 17, 18 of the memory cells 4 are then implanted with self-aligned process with respect to the polysilicon conductive layers, as shown in figure 4D. In this step the circuitry is still protected by the second mask.

Once the second mask is removed, a third mask 19 is formed on the memory device provided with openings which are realised in correspondence with the source regions 17 of the memory cells, as shown in figure 4E.

The field oxide layer is then etched which insulates from each other the active areas of memory cells 4 belonging to pairs of adjacent word lines and a self-aligned implant step is carried out for realising the connection of these memory cells to a common source region of the memory cells belonging to pairs of adjacent word lines. In this step the circuitry remains covered.

Once the third mask 19 is removed, gate electrodes 20 of the low voltage transistors are formed, by using a photo-lithographic process which provides the use of a fourth mask provided with openings in correspondence with the portion C of the semiconductor substrate 1. This fourth mask completely covers the first and the second portion A, B of the semiconductor substrate 1. Through the openings of the fourth mask the third conductive layer 11 is etched, as shown in figure 5C. Advantageously, also the third insulating layer 10 is removed.

Once the fourth mask is removed, advantageously, a re-oxidation thermal treatment of the whole memory device is carried out, forming an oxide layer 21 on all the exposed conductive layers.

Nothing forbids that this oxide layer 21 is deposited on the whole memory device 2. Advantageously, a further protective layer can be deposited on this oxide layer 21.

By means of conventional masking processes successive implantation steps are then carried out to form at least first portions of source drain regions 22 of the high voltage transistors 3 and at least first portions of source drain regions 23 of the low voltage transistors 5.

Nothing forbids that these at least first portions of the source drain regions 22 of the high voltage transistors 3 are realised prior to the formation of the first spacers 15.

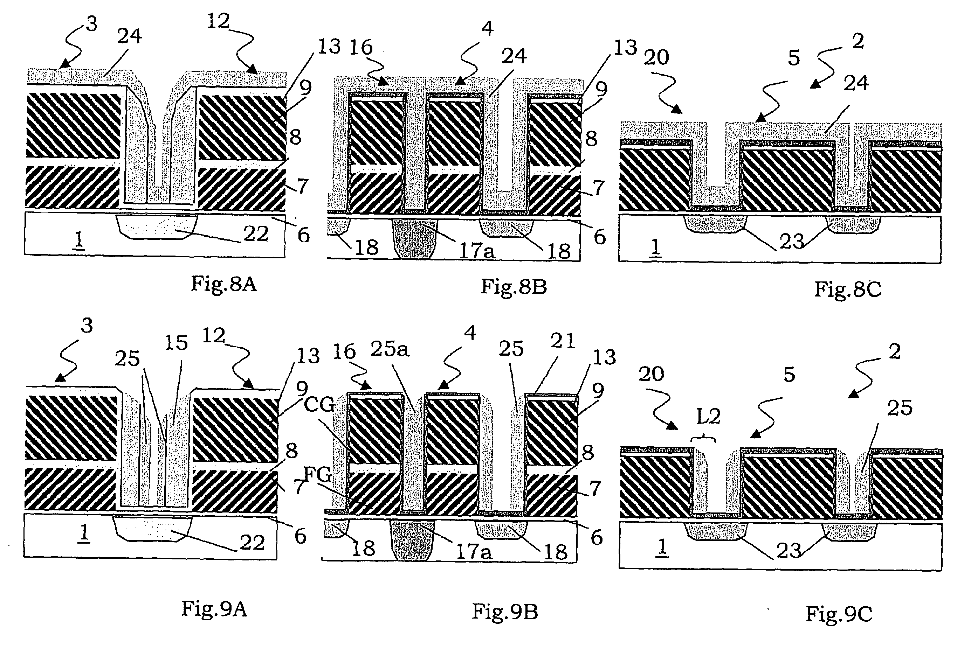

A second protective layer 21 is then formed on the whole memory device, which completely coats the gate electrodes 12 of the high voltage transistors 3 provided with first spacers 15 and the other gate electrodes 16, 20 which have been formed, as shown in figures 8A, 8B and 8C.

This second protective layer 24 can be formed also by a plurality of overlapped layers. This second protective layer 24 comprises a dielectric layer which can be etched in a highly selective way with respect to the second and to the third conductive layer 9, 11 and it is formed, for example, by one or more silicon oxide or silicon nitride layers.

An etching step, for example of the anisotropic type, of the second protective layer 24 is subsequently carried out to form second spacers 25 on the side walls of the gate electrodes 16, 20 of the memory cells 4 and of the low voltage transistors 5. Second spacers 25 are formed also on the side walls of the first spacers 15 of the high voltage transistors 3. These spacers 25 have a second length equal to L2, as shown in figures 9A, 9B and 9C.

On the side walls of the high voltage transistors 3 thick spacers are then formed being obtained by the sum of the first and second spacers 15, 25 having width equal to L1+L2, these thick spacers being indispensable to handle the high voltages.

As it can be noted in figure 9B, if the thickness of the second protective layer 24 is greater than half of the distance between two gate electrodes 16 of the adjacent memory cells 4, the etching step for realising the second spacers 25 does not completely remove the second protective layer 24 comprised between these two gate electrodes 16 of the adjacent memory cells 4 until the semiconductor substrate 1 is exposed, thereby a single spacer 25a will completely fill in the space between these two adjacent gate electrodes 16.

From now on the process goes on in a standard way, with the possibility of forming, if necessary, cobalt salicide layers in matrix and in circuitry,

In one embodiment of the process, if it is not necessary to form spacers 25 on the side walls of the memory cells 4, the first protective layer 14 is deposited with a thickness suitable for the formation of the final spacers of the high voltage transistors 3 having suitable dimensions, avoiding the successive deposition of the second protective layer 24 and the relative etching step forming the second spacers 25.

In conclusion, the process according to the invention allows to avoid the use of additional dedicated masks for the definition of differential spacers between circuitry comprising high voltage transistors 3 of the HV circuitry and the matrix of memory cells 4.

Although in the whole description reference has been made to high voltage transistors 3 of the HV circuitry with gate electrodes comprising two conductive layers separated by a dielectric, the process according to the invention can be also advantageously applied when the gate electrode of these high voltage transistors 3 is formed by a sole conductive layer. In this embodiment, for example in the process flow here described, during the definition step of the width W of the floating gate electrodes, the first conductive layer 7 is completely removed by the first portion of semiconductor substrate 1, thereby the gate electrodes of the high voltage transistors 3 are formed only by the second conductive layer 7.

Nothing forbids however that if the gate electrodes of these high voltage transistors 3 is formed by a sole conductive layer, this layer is a further layer deposited on the semiconductor substrate 1, different from the second conductive layer 7.

## Claims

1. Process for manufacturing a non volatile memory electronic device (2) integrated on a semiconductor substrate (1) which comprises a matrix of non volatile memory cells (4), said memory cells (4) organised in rows, called word lines, and columns, called bit lines and an associated circuitry comprising high voltage transistors (3), the process comprising the steps of:
- funding, by means of a photo-lithographic process which provides the use of a first photo-lithographic mask, gate electrodes (12) of said high voltage transistors (3) projecting from a first portion (A) of said semiconductor substrate (1),
- forming first spacers (15) on the side walls of said gate electrodes (12) of said high voltage transistors (3) of a first length (L1),
- forming, by means of a photo-lithographic process which provides the use of a second photo lithographic mask which covers said high voltage transistors (3), gate electrodes (16) of said memory cells (4) projecting from a second portion (B) of said semiconductor substrate (1), each of said gate electrodes (16) of memory cells (4) comprising a floating gate electrode (FG) and a control gate electrode (CG).

2. Process for manufacturing a memory electronic device (2) according to claim 1, **characterised in that** it comprises the step of:
- forming second spacers (25) on the side walls of at least one gate electrode (12) of said memory cells (4) and of said first spacers (15) of a second length (L2).

3. Process for manufacturing a memory electronic device (2) according to claim 1, **characterised in that**, before forming said first spacers (15), source and drain regions (22) of said high voltage transistors (3) are formed.

4. Process for manufacturing a memory electronic device (2) according to claim 1 or 2, wherein said circuitry comprises low voltage transistors (5), **characterised in that** it comprises the step of:
- forming, by means of a photo-lithographic process which provides the use of a third photo-lithographic mask, gate electrodes (20) of said low voltage transistors (5) projecting from a third portion of said semiconductor substrate (1), each of said gate electrodes (20) of said low voltage transistors (5) comprising a third dielectric layer (10) and a third conductive layer (11).

5. Process for manufacturing a memory electronic device (2) according to claim 4, **characterised in that** it comprises the step of:
- forming second spacers (25) on the side walls of said gate electrodes (20) of said low voltage transistors (5) a second length (L2).

6. Process for manufacturing a memory electronic device (2) according to claim 4, **characterised in**:
- forming source and drain regions (23) of said low voltage transistors (5) after having completed said memory cells (4).

7. Process for manufacturing a memory electronic device (2) according to claim 1, **characterised in that** the step of forming said first spacers (15) comprises the steps of:
- forming a first protective layer (14) on the whole memory electronic device (2) coating said gate electrodes (12) of said high voltage transistors (3),
- etching said first protective layer (14) forming said spacers (15) on the side walls of said gate electrodes (12) of said high voltage transistors (3) and completely removing it from said second portion (B) of said semiconductor substrate (1).

8. Process for manufacturing a memory electronic device (2) according to claim 2, **characterised in that** the step of forming said second spacers (25) comprises the step of:
- forming a second protective layer (24) on whole of said memory electronic device (2) which coats said gate electrodes (12) of said high voltage transistors (3) provided with said first spacers (15) and said gate electrodes (16) of said memory cells (4),
- etching said second protective layer (24) forming said second spacers (15) on the side walls of said gate electrodes (12) of said high voltage transistors (3) provided with first spacers (15) and on at least one of said gate electrodes (16) of said memory cells (4).

9. Process for manufacturing a memory electronic device (2) according to claim 1, **characterised in that** said non volatile memory cells (4) are of the Flash type and organised with architectures of the NOR or NAND type.

10. Process for manufacturing a memory electronic device (2) according to claim 1, **characterised in that** said first and second protective layers (14, 24) are formed by silicon oxide or silicon nitride layers.

11. Process for manufacturing a memory electronic device (2) according to claim 1, **characterised in that** it forms source, drain regions (1.7, 18) of said memory cells (4) after having formed said gate electrodes (16) of memory cells (4).
